# DEMANDE DE BREVET EUROPEEN

(11) **EP 0 989 672 A2**
(43) Date de publication de la demande: **29.03.2000**
(21) Numéro de dépôt: 99402334.9
(22) Date de dépôt: 23.09.1999
(51) Int. Cl.: H03K 17/96

(54) **Douille pour appareil d'éclairage**

(30) Priorité: 23.09.1998 FR 9811882
(71) Demandeur: Acti-Lux, 75015 Paris (FR)
(72) Inventeur: MAUGER, Jean-Michel, 92130 ISSY-LES-MOULINEAUX (FR); AMAURY, Georges, 78350 JOUY EN JOSAS (FR)
(74) Mandataire: Pontet, Bernard

(57) **Abrégé**

Douille (1, 1') pour appareil d'éclairage, comprenant un boîtier (2) en deux parties pouvant être accouplées, et un circuit électronique de variation de puissance (10) inséré dans ce boîtier. Ce circuit électronique est connecté, d'une part à des câbles d'alimentation électrique (61, 62) issus du corps (6) de l'appareil d'éclairage, et d'autre part à un récepteur de culot de lampe, et comporte une entrée de commande (E) prévue pour recevoir un signal de commande généré par un dispositif de commande tactile comportant une surface de contact (600).

Le circuit électronique (10) comprend en outre une pièce élastique de connexion électrique (4), telle qu'un ressort, ayant une première extrémité (41) à l'entrée de commande (E) et une seconde extrémité (42) disposée de façon à être en contact électrique permanent avec une pièce métallique disposée dans le fond du boîtier et assurant une fonction de conducteur d'un signal de détection capacitive.

Utilisation pour la miniaturisation et l'intégration de variateurs électroniques de faible et forte puissance dans des douilles d'appareil d'éclairage

Voir figure 1.

## Description

La présente invention concerne une douille pour appareil d'éclairage. Il s'agit ici d'appareils d'éclairage d'intérieur, tels que des luminaires sur pied ou sur socle, des lampes d'intérieur, de bureau ou de chevet, et des appliques, pour des logements ou des locaux professionnels ou administratifs, publics ou privés

Il existe un marché important pour des appareils d'éclairage d'intérieur équipés notamment d'ampoules dites halogènes et pourvus de variateurs de puissance électroniques. Dans le cas des lampadaires, ces variateurs de puissance sont disposés entre un câble d'alimentation secteur et un câble d'alimentation du lampadaire et sont réglables par action du pied ou de la main d'un utilisateur. Il existe également des variateurs de puissance inclus dans un boîtier variateur encastré à demeure dans un mur.

Par ailleurs, des appareils d'éclairage d'intérieur sont pourvus de variateurs de puissance à commande tactile. Le document WO 9825347 au nom du présent déposant divulgue ainsi un dispositif de commande tactile comprenant des moyens pour détecter une commande tactile effectuée sur une zone tactile prévue sur un appareil d'éclairage, ces moyens de détection comprenant des moyens pour capter, à partir d'une zone électriquement conductrice située à proximité de la zone tactile ou de la zone tactile elle-même, un courant de fuite sur cette zone tactile, et des moyens pour traiter le signal de courant de fuite ainsi capté.

Un simple toucher sur le tube d'un lampadaire ou le corps d'une lampe suffit pour allumer ou éteindre. Si le contact est maintenu, l'intensité de la lumière varie en continu et le dispositif de commande tactile mémorise le dernier réglage de la lumière.

Dans ce type d'appareil d'éclairage, la zone tactile peut être constituée par tout ou partie du corps de l'appareil d'éclairage, par exemple le tube vertical d'un lampadaire ou le pied d'une lampe avec abat-jour. Dans ce cas, l'appareil est isolé de la terre pour être totalement tactile.

Mais il existe également des appareils d'éclairage dans lesquels la commande tactile s'effectue sur une zone réduite et localisée de l'appareil, par exemple une pièce métallique telle qu'une bille, une tige ou un bouton. Cette pièce métallique servant de zone tactile est alors isolée du reste de l'appareil.

Même si les variateurs de puissance mis en oeuvre dans ces appareils d'éclairage à commande tactile présentent actuellement un haut niveau de compacité, il existe cependant une demande pour disposer de variateurs de puissance miniaturisés pouvant être directement logés dans des douilles de lampes et de lampadaires.

On connaît déjà des douilles intégrant un variateur de puissance à commande tactile. Des douilles de ce type incluent dans un boîtier un circuit électronique pourvu d'une entrée de commande à laquelle est fixée une extrémité d'un câble conducteur souple isolé. Lors du montage de la douille, l'autre extrémité de ce câble de liaison doit être connectée, par exemple par soudure, à une tige de détection faisant fonction de zone tactile et s'étendant à l'extérieur de la douille. Ce câble doit avoir une longueur suffisante pour permettre de réaliser les opérations de connexion. Après connexion, le circuit électronique est alors inséré à l'intérieur de la douille. Cette opération d'insertion peut être rendue délicate par la présence du câble de liaison du fait de la longueur de ce dernier. De plus, en cas de défaillance ou de maintenance du circuit électronique, son remplacement s'avère difficile puisqu'il est nécessaire de supprimer la connexion par câble existant entre le circuit électronique et la tige de détection.

Le but de l'invention est de remédier à ces inconvénients en proposant un nouveau concept de douille à variateur de puissance intégré permettant un montage et un démontage aisés de la douille tout en assurant un fonctionnement fiable, et qui en outre puisse être mis en oeuvre pour des appareils d'éclairage dont tout ou partie de la structure constitue une zone tactile.

Cet objectif est atteint avec une douille pour appareil d'éclairage, comprenant:
- un boîtier constitué d'une partie supérieure de forme sensiblement annulaire comportant des moyens pour recevoir le culot d'une ampoule et d'une partie inférieure de forme sensiblement cylindrique comportant des moyens pour relier mécaniquement la douille au corps de l'appareil d'éclairage, lesdites parties respectivement supérieure et inférieure étant pourvues chacune de moyens d'accouplement,
- un circuit électronique de variation de puissance disposé au sein de la partie inférieure, connecté à des câbles d'alimentation électrique issus du corps de l'appareil d'éclairage pour recevoir une tension d'alimentation secteur, et à des moyens de contact électrique avec les deux pôles du culot d'une ampoule pour fournir à cette ampoule une tension réglable, ce circuit électronique étant en outre pourvu d'une entrée de commande prévue pour recevoir un signal de commande généré par des moyens de commande tactile comportant une surface de contact et des moyens électriquement conducteurs pour détecter un effet capacitif induit sur cette surface de contact.

Suivant l'invention, le circuit électronique comprend en outre des moyens élastiques de connexion électrique ayant une première extrémité reliée à l'entrée de commande et une seconde extrémité disposée de façon à être en contact électrique permanent avec les moyens de détection tant que le circuit électronique est inséré dans la partie inférieure du boîtier.

Ainsi, le câblage des appareils d'éclairage pourvus de cette douille est grandement simplifié. En effet, au montage, il suffit désormais de réaliser les connexions électriques entre les conducteurs du câble d'alimentation secteur et les bornes d'entrée de puissance du circuit électronique, la liaison électrique entre l'entrée de commande de ce circuit et les moyens de détection de commande tactile étant immédiatement réalisée par les moyens élastiques de connexion électrique dès lors que le circuit électronique est maintenu inséré dans la douille. Il s'en suit un gain considérable dans le temps de montage d'une telle douille. En outre, en cas d'intervention sur la douille, le retrait du circuit électronique hors du boîtier s'avère particulièrement aisé puisqu'aucune connexion fixe à demeure n'est réalisée entre le circuit électronique et une pièce de détection ou de liaison électrique solidaire de la douille.

Dans une première version de réalisation d'une douille selon l'invention, dans laquelle la surface de contact est constituée par tout ou partie du corps de l'appareil d'éclairage, les moyens de liaison mécanique comprennent une pièce électriquement conductrice reliée aux moyens de détection, et la seconde extrémité des moyens élastiques de connexion électrique est en contact mécanique et électrique permanent avec cette pièce électriquement conductrice tant que le circuit électronique est inséré dans la partie inférieure du boîtier.

Lorsque les moyens de liaison mécanique comprennent une pièce métallique de forme sensiblement annulaire à travers laquelle passent les câbles d'alimentation électrique, cette pièce métallique étant disposée dans un évidement ménagé au bas de la partie inférieure et étant pourvue d'un filetage intérieur pour recevoir l'extrémité supérieure filetée d'une pièce tubulaire, la seconde extrémité des moyens élastiques de connexion électrique vient en appui contre cette pièce métallique.

Dans une seconde version de réalisation d'une douille selon l'invention, dans laquelle la surface de contact est constituée par la surface d'une tige de détection électriquement conductrice insérée partiellement dans un trou ménagé latéralement dans la partie inférieure du boîtier, les moyens élastiques de connexion électrique sont agencés de sorte que leur seconde extrémité vient en contact électrique et mécanique permanent avec une portion intérieure de ladite tige de détection tant que le circuit électronique est inséré dans la partie inférieure du boîtier.

Dans une forme préférée de réalisation d'une douille selon l'invention, les moyens élastiques de connexion électrique comprennent un ressort hélicoïdal réalisé dans un matériau électriquement conducteur, par exemple du bronze-béryllium.

Mais les moyens élastiques de connexion électrique pourraient tout autant être réalisés à partir d'une lame souple métallique ou de tout autre élément assurant une liaison à la fois élastique et électriquement conductrice.

Dans le cas d'une réalisation d'une douille selon l'invention pour des appareils d'éclairage de puissance élevée, par exemple 200 W, on dote alors celle-ci de moyens pour réaliser une barrière thermique entre d'une part, une zone du boîtier qui est à proximité immédiate du culot d'une ampoule et est donc à une température de fonctionnement élevée, et d'autre part, le circuit électronique, de sorte que la température dudit circuit électronique est maintenue à une température sensiblement inférieure admissible pour les composants dudit circuit électronique.

Les moyens pour réaliser une barrière thermique comprennent de préférence des première et seconde pièces métalliques d'évacuation thermique de forme sensiblement annulaire pourvues sur leur périphérie de surfaces d'évacuation thermique, et une pièce d'isolation thermique de forme sensiblement annulaire disposée entre lesdites première et seconde pièces métalliques d'évacuation thermique. La pièce d'évacuation thermique et la pièce d'isolation thermique peuvent en pratique être disposées en haut de la partie inférieure du boîtier. En outre, il est avantageux de prévoir dans la partie inférieure du boîtier des fentes d'aération.

D'autres particularités et avantages de l'invention ressortiront encore de la description ci-après, relative à des exemples non limitatifs.

Aux dessins annexés :
- la figure 1 est une vue en perspective partiellement éclatée d'un premier exemple de réalisation d'une douille selon l'invention;
- la figure 2 est une vue en perspective partiellement éclatée d'un second exemple de réalisation d'une douille selon l'invention, pourvue d'une tige de détection;
- la figure 3 illustre les étapes essentielles du câblage et du montage d'une douille selon l'invention; et
- la figure 4 représente une vue en coupe partielle d'un troisième exemple de réalisation d'une douille selon l'invention, pourvue d'une isolation thermique.

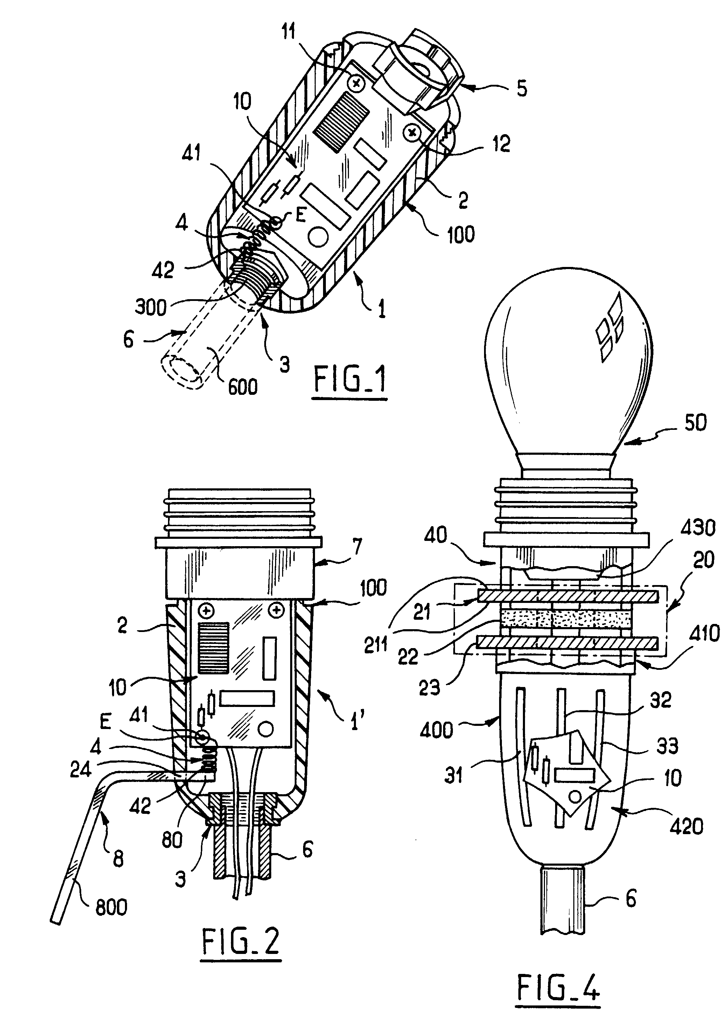

On va maintenant décrire un premier exemple de réalisation d'une douille selon l'invention, en référence à la figure 1.

La douille 1 est ici représentée en coupe partielle sans sa partie supérieure. Il peut par exemple s'agir d'une douille de type E27 pourvue d'un variateur de puissance 60W. Elle comporte au sein de la partie inférieure 2 du boîtier 100 un circuit électronique de variation de puissance 10 comprenant deux bornes 11, 12 d'entrée de tension d'alimentation secteur, un dispositif 5 d'accouplement du culot d'une ampoule (non représentée) fixé sur la partie supérieure du circuit électronique et une entrée E de commande tactile.

Pour la description de la structure interne du circuit électronique 10, on se référera utilement au document WO 9825347 précité qui décrit de manière détaillée un dispositif de commande tactile pouvant être directement utilisé dans une douille selon la présente invention. D'une manière générale, un dispositif de commande tactile de ce type comprend une partie de contrôle et une partie de puissance comportant un triac faisant fonction d'interrupteur bidirectionnel commandé et contrôlant l'alimentation électrique d'une ampoule à partir d'une source de tension alternative monophasée. La partie de contrôle est généralement réalisée autour d'un circuit de contrôle de phase disponible dans le commerce, recevant un signal de courant de fuite provenant de la zone tactile prévue sur l'appareil d'éclairage ainsi équipé.

Le circuit électronique 10 est pourvu d'un ressort 4 réalisé dans un matériau électriquement conducteur, par exemple en bronze-béryllium, dont une première extrémité 41 est fixée à l'entrée de commande E et la seconde extrémité est libre, l'axe principal de ce ressort étant sensiblement parallèle à l'axe principal du boîtier 100 de la douille.

En position normale du circuit électronique 10 au sein du boîtier 100, l'extrémité libre 42 du ressort conducteur 4 est en contact électrique et mécanique avec une pièce de liaison mécanique 3 fixée dans un évidement ménagé au fond de la partie inférieure 2 du boîtier 100. Cette pièce de liaison mécanique 3 présente par exemple une forme extérieure polygonale et un trou central pourvu d'un filetage intérieur 300 prévu pour le vissage d'une pièce tubulaire 6 munie à son extrémité supérieure d'un filetage extérieur. La surface extérieure 600 de cette pièce tubulaire est utilisée comme surface de commande tactile. La pièce de liaison mécanique 3, à travers laquelle on fait passer les conducteurs d'alimentation électrique, est réalisée dans un matériau électriquement conducteur et se trouve en contact électrique avec la surface intérieure de la pièce tubulaire 6 qui fait fonction de zone de détection de courant de fuite à proximité immédiate de la surface extérieure 600 qui constitue la zone tactile. Grâce au contact électrique réalisé par le ressort conducteur 4 en compression entre la pièce de liaison mécanique 3 elle-même reliée électriquement à la zone de détection et l'entrée de commande E, le circuit électronique 10 reçoit les signaux de courant de fuite qui sont ensuite traités pour générer une commande d'éclairage.

On va maintenant décrire, en référence à la figure 2, un second exemple de réalisation d'une douille 1' selon l'invention, dans lequel la zone de commande tactile est constituée par la surface externe 800 d'une tige de détection 8 réalisée dans un matériau électriquement conducteur. Cette tige 8, qui peut présenter par exemple une forme coudée, est partielle insérée dans la partie inférieure 2 du boîtier 100 par un trou 24 ménagé dans la paroi latérale de ladite partie inférieure. Lorsque le circuit électronique 10 est maintenu inséré dans la partie inférieure 2 par vissage de la partie supérieure 7 du boîtier 100, le ressort conducteur 4 se trouve comprimé en appui contre l'extrémité interne 80 de la tige de détection 8 et l'entrée de commande E du circuit électronique peut alors recevoir les signaux de détection de courant de fuite.

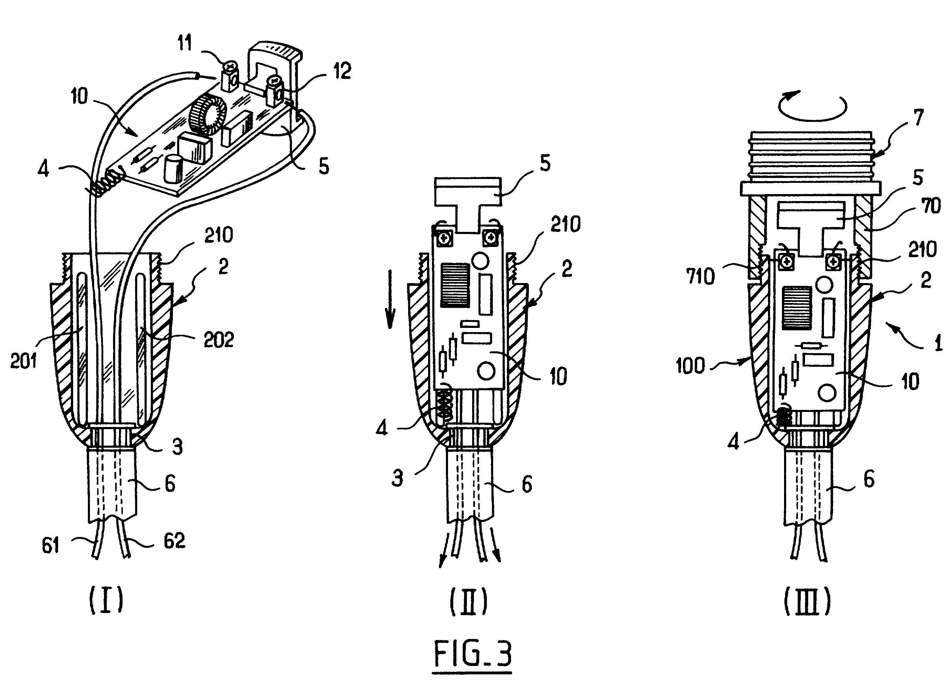

Les étapes principales de câblage et de montage d'une douille selon l'invention vont maintenant être décrites, en référence à la figure 3. Dans une première étape (I), on effectue les connexions électriques des câbles d'alimentation électrique 61, 62 transitant via la pièce tubulaire 6 et la pièce de liaison 3, sur les bornes d'alimentation 11, 12 du circuit électronique 10. Ces connexions sont réalisées alors que le circuit électronique 10 est à l'extérieur de la douille 1.

On insère ensuite le circuit électronique 10 dans la partie inférieure 2 du boîtier 100, le long de deux rails de guidage 201, 202 prévus dans la paroi interne de la partie inférieure 2 (étape II). L'extrémité libre du ressort 4 entre alors en contact avec la pièce de liaison mécanique 3 faisant fonction d'élément de conduction des signaux de détection de courant de fuite.

On effectue alors un vissage de la partie supérieure 7 pourvue d'un filetage intérieur 710 dans l'extrémité filetée 210 de la partie inférieure 2 (étape III). Le circuit électronique 10 est alors maintenu inséré à l'intérieur du boîtier 100 et le ressort conducteur 4 en situation de compression maintient un contact électrique fiable entre la zone de détection de courant de fuite et l'entrée de commande E du circuit électronique 10. La douille 1 ainsi montée est directement en état de marche sans autre intervention.

Dans le cas d'un appareil d'éclairage de puissance significative, par exemple supérieure à 100 W et typiquement de l'ordre de 250 W, il devient nécessaire de prévoir une isolation thermique entre la région de la douille recevant le culot d'une ampoule qui peut atteindre des températures supérieures à 200°C et le circuit électronique qui ne doit pas dépasser une température d'environ 70°C. En référence à la figure 4, une douille 40 selon l'invention permettant ce type d'utilisation comprend un module de barrière thermique 20 disposé entre une pièce support de culot 430 à haute température et la partie inférieure 420 du boîtier 400 prévue pour contenir le circuit électronique 10. Le module de barrière thermique 20 comprend une première pièce métallique 21 de forme annulaire s'étendant radialement au delà de la périphérie du boîtier pour fournir des zones d'évacuation thermique 211 faisant fonction de radiateur, une pièce d'isolation thermique 22 réalisé dans un matériau isolant tel que de la poudre de Bakélite chargée, et une seconde pièce métallique 23 qui peut être de structure semblable à celle de la première pièce métallique 21. Les deux pièces métalliques peuvent être réalisées dans un alliage d'aluminium du type AG3. La pièce d'isolation thermique 22 disposée entre les deux pièces métalliques 21, 23, est agencée de façon à ne pas être en contact avec les deux pièces métalliques. Les zones d'évacuation thermique sont de préférence conçues pour offrir une surface optimale d'évacuation thermique, selon des techniques connues en matière de conception de radiateur thermique.

En outre, la partie inférieure 420 du boîtier 400 comporte des fentes d'aération 31, 32, 33 permettant une circulation d'air à l'intérieur du boîtier de façon notamment à évacuer au mieux la chaleur générée par les composants de puissance du circuit électronique 10.

A titre d'exemple de réalisation non limitatif, les pièces métalliques d'évacuation thermique et la pièce d'isolation peuvent avoir une épaisseur d'environ 2 à 5 mm avec un espace entre pièces d'environ 3 mm. Mais il est important de noter que les paramètres dimensionnels d'un module de barrière thermique sont en pratique déterminés en fonction du problème d'évacuation thermique spécifique de chaque douille selon l'invention. De plus, on pourrait envisager dans le cadre de la présente invention une conception de douilles comportant un dispositif d'isolation thermique constitué par un empilement de plusieurs modules de barrière thermique tels que décrits ci-dessus.

Il est à noter que le boîtier d'une douille selon l'invention peut être réalisé dans divers matériaux, notamment en matériau plastique, mais également en matériau métallique. Par ailleurs, on peut prévoir que le circuit électronique intégré dans une douille selon l'invention puisse être conçu pour pouvoir également bénéficier d'une télécommande HF, ce qui améliore ainsi le confort d'utilisation.

Bien entendu, l'invention n'est pas limitée aux exemples décrits et représentés. On peut ainsi concevoir de nombreux autres types d'appareils d'éclairage électrique munis d'une douille selon l'invention.

En particulier, les supports tactiles peuvent être soit métalliques, soit à base de matériaux non conducteurs tels que le bois, la céramique ou le verre, sans altération esthétique de ces matériaux. On prévoit alors dans le cas de matériaux non conducteurs un traitement préalable de la paroi intérieure des supports comme cela est divulgué dans le document WO 9825347 précité.

## Revendications

1. Douille (1, 1') pour appareil d'éclairage, comprenant:
- un boîtier (2) constitué d'une partie supérieure (7) de forme sensiblement annulaire comportant des moyens (5) pour recevoir le culot d'une ampoule et d'une partie inférieure (2) de forme sensiblement cylindrique comportant des moyens (3) pour relier mécaniquement la douille (1) au corps (6) de l'appareil d'éclairage, lesdites parties respectivement supérieure et inférieure (7, 2) étant pourvues chacune de moyens d'accouplement (710, 210),
- un circuit électronique de variation de puissance (10) disposé au sein de la partie inférieure (2), connecté à des câbles d'alimentation électrique (61, 62) issus du corps (6) de l'appareil d'éclairage pour recevoir une tension d'alimentation secteur, et à des moyens de contact électrique avec les deux pôles du culot d'une ampoule pour fournir à cette ampoule une tension réglable, ce circuit électronique (10) étant en outre pourvu d'une entrée de commande (E) prévue pour recevoir un signal de commande généré par des moyens de commande tactile (8, 6) comportant une surface de contact (800, 600) et des moyens pour détecter un effet capacitif induit sur cette surface de contact,
caractérisée en ce que le circuit électronique (10) comprend en outre des moyens élastiques de connexion électrique (4) ayant une première extrémité (41) reliée à l'entrée de commande (E) et une seconde extrémité (42) disposée de façon à être en contact électrique permanent avec les moyens de détection tant que le circuit électronique (10) est maintenu inséré dans la partie inférieure (2) du boîtier (100).

2. Douille (1) selon la revendication 1, dans laquelle la surface de contact est constituée par tout ou partie du corps (6) de l'appareil d'éclairage, caractérisée en ce que les moyens de liaison mécanique comprennent une pièce électriquement conductrice (3) reliée aux moyens de détection, et en ce que la seconde extrémité (42) des moyens élastiques de connexion électrique (4) est en contact électrique permanent avec cette pièce électriquement conductrice (3) tant que le circuit électronique (10) est maintenu inséré dans la partie inférieure (2) du boîtier (100).

3. Douille (1) selon la revendication 2, dans laquelle les moyens de liaison mécanique comprennent une pièce métallique (3) de forme sensiblement annulaire à travers laquelle passent les câbles d'alimentation électrique (61, 62), cette pièce métallique (3) étant disposée dans un évidement ménagé au bas de la partie inférieure (2) et étant pourvue d'un filetage intérieur pour recevoir une extrémité supérieure filetée d'une pièce tubulaire (6), caractérisée en ce que la seconde extrémité (42) des moyens élastiques de connexion électrique (4) vient en appui contre cette pièce métallique (3).

4. Douille (1') selon la revendication 1, dans laquelle la surface de contact est constituée par la surface externe (800) d'une tige de détection électriquement conductrice (8) insérée partiellement dans le boîtier de la douille (1') par un trou (24) ménagé latéralement dans la partie inférieure (2) du boîtier (100), caractérisée en ce que les moyens élastiques de connexion électrique (4) sont agencés de sorte que leur seconde extrémité (42) vient en contact électrique permanent avec une portion intérieure (80) de ladite tige de détection (8) tant que le circuit électronique (10) est inséré dans la partie inférieure (2) du boîtier (100).

5. Douille (1, 1') selon l'une quelconque des revendications précédentes, caractérisée en ce que les moyens élastiques de connexion électrique (4) comprennent un ressort hélicoïdal réalisé dans un matériau électriquement conducteur.

6. Douille selon l'une quelconque des revendications 1 à 4, caractérisée en ce que les moyens élastiques de connexion électrique comprennent une lame souple métallique.

7. Douille (40) selon l'une quelconque des revendications précédentes, caractérisée en ce qu'elle comprend en outre des moyens (20) pour réaliser une barrière thermique entre une zone du boîtier (400) à proximité immédiate du culot d'une ampoule (50) avec une température de fonctionnement élevée, et le circuit électronique, de sorte que la température dudit circuit électronique est maintenue à une température sensiblement inférieure à une température admissible pour les composants dudit circuit électronique.

8. Douille (40) selon la revendication 7, caractérisée en ce que les moyens pour réaliser une barrière thermique comportent un module de barrière thermique comprenant des première et seconde pièces métalliques d'évacuation thermique (21, 23) de forme sensiblement annulaire pourvues sur leur périphérie de surfaces (211) d'évacuation thermique et une pièce d'isolation thermique (22) de forme sensiblement annulaire disposée entre lesdites première et seconde pièces métalliques d'évacuation thermique (21, 23).

9. Douille selon la revendication 8, caractérisée en ce que les moyens de barrière thermique comprennent un empilement de plusieurs modules de barrière thermique.

10. Douille (40) selon l'une des revendications 8 ou 9, caractérisée en ce que la partie inférieure (420) du boîtier (400) est pourvue de fentes d'aération (31-33).
